(19) Europäisches Patentamt

European Patent Office

Office européen des brevets

(11) **EP 1 046 919 A2**

(12) **EUROPÄISCHE PATENTANMELDUNG**

(43) Veröffentlichungstag:
**25.10.2000 Patentblatt 2000/43**

(51) Int. Cl.[7]: **G01R 19/165**

(21) Anmeldenummer: **00107387.3**

(22) Anmeldetag: **05.04.2000**

(84) Benannte Vertragsstaaten:
**AT BE CH CY DE DK ES FI FR GB GR IE IT LI LU
MC NL PT SE**
Benannte Erstreckungsstaaten:
**AL LT LV MK RO SI**

(30) Priorität: **21.04.1999 DE 19918042**

(71) Anmelder:
**Infineon Technologies AG
81541 München (DE)**

(72) Erfinder:
• **Kucher, Andreas
9500 Villach (AT)**
• **Wachter, Franz, Dr.
9504 Villach (AT)**

(74) Vertreter:
**Zedlitz, Peter, Dipl.-Inf.
Siemens AG,
Patentabteilung,
Postfach 22 16 34
80506 München (DE)**

(54) **Schaltungsanordnung zur Unterstromerkennung an einem MOS-Leistungstransistor**

(57) Es wird eine Schaltungsanordnung zur Unterstromerkennung an einem MOS-Leistungstransistor beschrieben, die sich insbesondere auszeichnet durch eine erste Schaltungseinheit zur Erzeugung eines Stromspiegels mit einem ersten Transistor (M1), mit der bei geringem Laststrom an dem Leistungstransistor (M2) die an diesem abfallende Spannung mit einer ersten Referenzspannung verglichen und bei Unterschreiten der ersten Referenzspannung ein Unterstromsignal erzeugt wird, sowie eine zweite Schaltungseinheit zur Begrenzung der Drainspannung des Leistungstransistors (M2) bei hohem Laststrom auf einen maximalen Wert.

FIG 3

EP 1 046 919 A2

**Beschreibung**

Die Erfindung betrifft eine Schaltungsanordnung zur Unterstromerkennung an einem MOS-Leistungstransistor gemäß dem Oberbegriff des Anspruchs 1, insbesondere zur Anwendung mit einem DMOS-Schalter für die Automobilelektronik.

DMOS-Schalter werden in verschiedenen Halbleiter-Fertigungs-Technologien (z.B. SPT, BCD, SmartMOS) realisiert. Da der Spannungsabfall $V_{DS}$ (Drain-Source-Spannung) an einem solchen DMOS-Schalter unter allen Bedingungen, das heißt insbesondere bei jeder Umgebungstemperatur und maximalem Strom kleiner als 0,6 V sein soll, muß eine Strommessung indirekt und somit ohne Eingriffe in den Leistungspfad erfolgen.

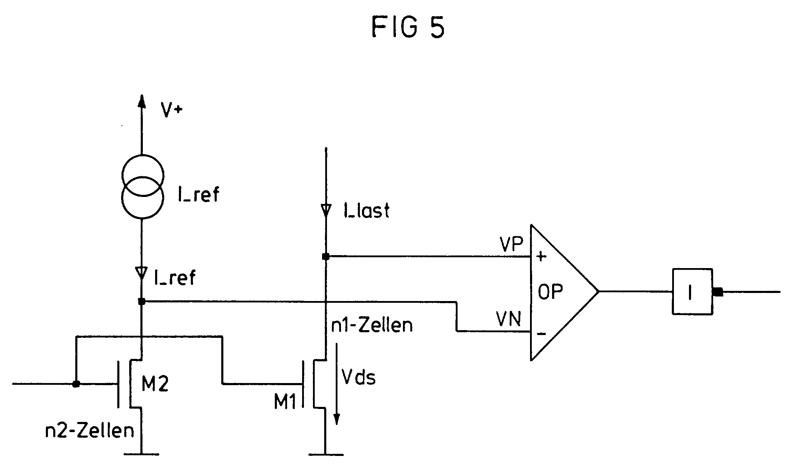

Zu diesem Zweck ist eine Schaltung zur Unterstromerkennung bekannt, die in Figur 5 dargestellt ist. Diese Schaltung umfaßt einen DMOS-Schalttransistor M1 (n1-Zellen), durch den ein Laststrom $I_{last}$ fließt und an dem eine Spannung $V_{DS}$ abfällt, eine Stromquelle $I_{ref}$ zur Erzeugung eines Referenzstroms durch einen zweiten Transistor M2 (n2-Zellen), sowie einen Operationsverstärker Op, an dessen Ausgang ein Inverter I anliegt.

Die über den beiden Transistoren M1, M2 abfallenden Spannungen liegenden an einem nichtinvertierenden bzw. einem invertierenden Eingang VP, VN des Operationsverstärkers Op an und betragen $VP = RdsOn(M1) * I_{last}$ bzw. $VN = RdsOn(M2) * I_{ref}$, wobei $RdsOn(M2) = RdsOn(M1) * (n1/n2)$ ist und n1 und n2 die Anzahl von Zellen des jeweiligen Transistors M1, M2 bezeichnet.

Beträgt der Durchgangswiderstand RdsOn(M1) zum Beispiel nur etwa 1 Ohm und der Laststrom $I_{last}$ nur etwa 3 mA, so entsteht dabei ein Spannungsabfall von nur etwa 3 mv. Diese Spannung ist kleiner, als die übliche Offsetspannung eines Operationsverstärkers bei dem verwendeten Prozeß. Eine Unterstromerkennung kann deshalb in diesem Bereich mit dieser Schaltung nicht realisiert werden.

Der Erfindung liegt die Aufgabe zugrunde, eine Schaltungsanordnung zur Unterstromerkennung der eingangs genannten Art zu schaffen, mit der auch bei geringen Lastströmen ein Unterstrom sicher erkannt werden kann.

Diese Aufgabe wird gemäß den Merkmalen des Patentanspruchs 1 mit einer Schaltungsanordnung gelöst, die sich auszeichnet durch eine erste Schaltungseinheit zur Erzeugung eines Stromspiegels mit einem ersten Transistor, mit der bei geringem Laststrom an dem Leistungstransistor die an diesem abfallende Spannung mit einer ersten Referenzspannung verglichen und bei Unterschreiten der ersten Referenzspannung ein Unterstromsignal erzeugt wird, sowie eine zweite Schaltungseinheit zur Begrenzung der Drainspannung des Leistungstransistors bei hohem Laststrom auf einen maximalen Wert.

Ein besonderer Vorteil dieser Lösung besteht darin, daß entsprechend den spezifizierten Anforderungen an den Spannungsabfall der Drain-Source-Spannung des DMOS-Ausgangstransistors mit einer Drain-Source-Spannung von kleiner 0,6 V ein Unterstrom im Bereich von 2 bis 5 mA erkannt werden kann, wobei der Laststrom zwischen 0 und 400 mA liegen kann.

Die Unteransprüche haben vorteilhafte Weiterbildung der Erfindung zum Inhalt.

Danach ist der Leistungstransistor vorzugsweise ein DMOS-Transistor mit n1-Zellen und der erste Transistor ein MOS-Transistor mit n2-Zellen.

Ferner weist die erste Schaltungseinheit vorzugsweise eine Referenz-Stromquelle auf, wobei ein Unterstromsignal erzeugt wird, wenn der Laststrom $I_{last}$ kleiner oder gleich dem Wert von $I_{ref} * n1/n2$ ist.

Weitere Einzelheiten, Merkmale und Vorteile der Erfindung ergeben sich aus der folgenden Beschreibung einer bevorzugten Ausführungsform anhand der Zeichnung. Es zeigt:

Fig. 1 eine erste Schaltungseinheit einer erfindungsgemäßen Schaltung;

Fig. 2 eine zweite Schaltungseinheit einer erfindungsgemäßen Schaltung;

Fig. 3 eine Kombination der Schaltungseinheiten zu einer erfindungsgemäßen Schaltung;

Fig. 4 eine graphische Darstellung des Verlaufes der Drain-Source-Spannung über dem Strom und

Fig. 5 eine bekannte Schaltung zur Unterstromerkennung.

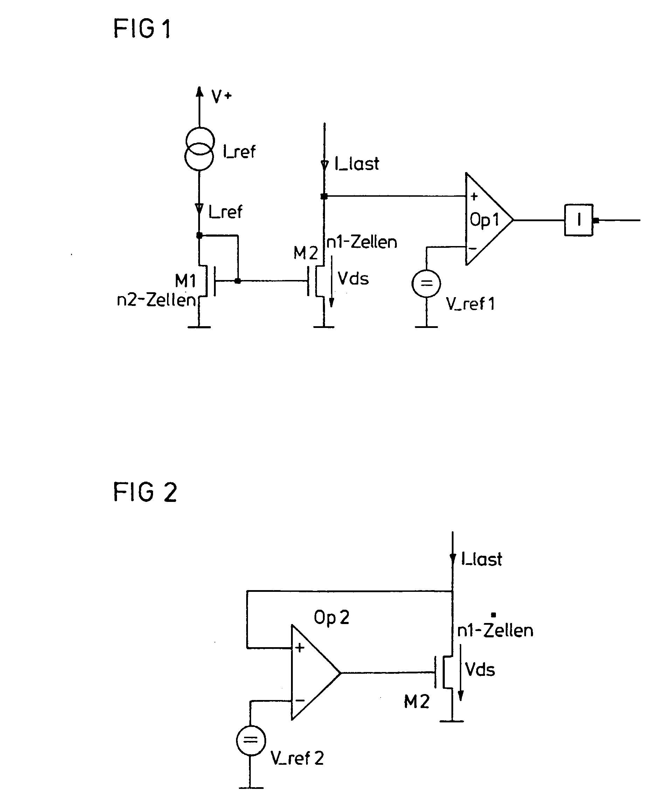

Zur Verdeutlichung des erfindungsgemäßen Prinzips sollen anhand der Figuren 1 und 2 zunächst zwei Schaltungseinheiten erläutert werden, aus denen sich die erfindungsgemäße Schaltung zusammensetzt.

Die erste Schaltungseinheit umfaßt gemäß Figur 1 eine Referenzstromquelle $I_{ref}$ zur Erzeugung eines Referenzstroms durch einen ersten MOS-Transistor M1 aus n2-Zellen. Die Basis (Gate) dieses ersten MOS-Transistors M1 ist ebenfalls mit der Referenzstromquelle $I_{ref}$ sowie mit der Basis (Gate) eines zweiten DMOS-Transistors M2 (Ausgangstransistor) aus n1-Zellen verbunden, durch den ein Laststrom $I_{last}$ fließt und an dem im durchgeschalteten Zustand eine Drain-Source-Spannung $V_{DS}$ abfällt. Diese Spannung liegt an einem nichtinvertierenden Eingang (+) eines ersten Operationsverstärkers Op1 an, dessen invertierender Eingang (-) mit einer ersten ReferenzSpannungsquelle $V_{ref1}$ verbunden ist. Der Ausgang des ersten operationsverstärkers Op1 ist über eine Inverter I geführt.

Diese erste Schaltungseinheit hat folgende Funktion: solange der Laststrom $I_{last}$ kleiner oder gleich dem Strom $I_{ref}$ * n1/n2 ist, ist auch die Drain-Source-Spannung $V_{DS}$ an dem zweiten DMOS-Ausgangstransistor M2 relativ klein. In diesem Fall ergibt sich bei einer geringen Laststromänderung eine auswertbare Änderung der Drain-Source-Spannung $V_{DS}$, so daß es möglich ist, einen kleinen Strom genau zu detektieren.

Wenn allerdings der Laststrom $I_{last}$ größer wird, als der Strom $I_{ref}$ * n1/n2 , so steigt die Drain-Source-Spannung $V_{DS}$ an dem zweiten DMOS-Ausgangstransistor stark an und würde den geforderten Wert von 0,6 V überschreiten.

Mit der in Figur 2 gezeigten zweiten Schaltungseinheit wird nun eine Ausregelung der Drain-Source-Spannung $V_{DS}$ auf einen Wert von weniger als 0,6 V realisiert. Zu diesem Zweck ist ein zweiter Operationsverstärker Op2 vorgesehen, dessen invertierender Eingang (-) mit einer zweiten Referenz-Spannungsquelle $V_{ref2}$ und dessen nichtinvertierender Eingang (+) mit der Drain-Source-Spannung $V_{DS}$ des zweiten Transistors M2 (n1-Zellen) verbunden ist, durch den der Laststrom $I_{last}$ fließt. Der Ausgang des zweiten Operationsverstärkers Op2 liegt an der Basis (Gate) dieses zweiten Transistors M2 (DMOS-Transistor) an.

Bei dieser zweiten Schaltungseinheit ist der Spannungsabfall immer kleiner als z.B. 0,6 V. Die Schaltungseinheit ermöglicht somit ein Treiben der geforderten Nominal-Lastströme von z.B. 400 mA bei einer Drain-Source-Spannung $V_{DS}$ von kleiner als 0,6 V. Allerdings kann man damit kleine Ströme z.B. im Bereich von 2 bis 4 mA kaum detektieren.

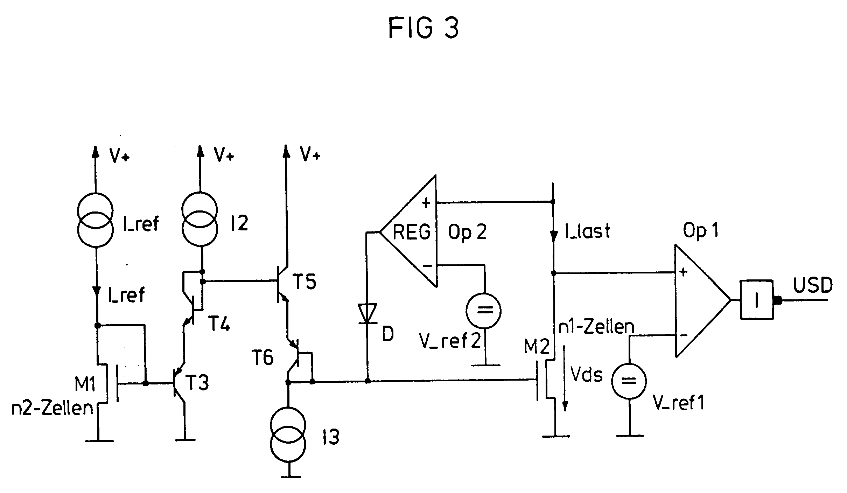

Eine erfindungsgemäße Schaltungsanordnung setzt sich gemäß Figur 3 aus einer Kombination der beiden Schaltungseinheiten zusammen.

Diese Schaltung umfaßt die Referenz-Stromquelle $I_{ref}$ zur Erzeugung des Referenzstroms durch den ersten Transistor M1 (n2-Zellen). Die Basis (Gate) des ersten Transistors M1 ist mit der Basis (Gate) eines dritten Transistors T3 sowie der Referenz-Stromquelle $I_{ref}$ verbunden. Der Emitter des dritten Transistors T3 ist mit dem Emitter eines vierten Transistors T4 verbunden, an dessen Basis und Kollektor eine zweite Stromquelle I2 anliegt. Dieser Anschluß ist außerdem zu der Basis eines fünften Transistors T5 geführt, dessen Kollektor mit einer positiven Versorgungsspannung +V und dessen Emitter mit dem Emitter eines sechsten Transistors T6 verbunden ist.

Basis und Kollektor des sechsten Transistors T6 liegen an einer dritten Stromquelle I3 an und sind außerdem zu der Basis (Gate) des zweiten (DMOS-)Transistors M2 (n1-Zellen) geführt. Der Ausgang des zweiten Operationsverstärkers Op2 ist über eine Diode D ebenfalls mit diesem Anschluß verbunden. Die an dem Ausgang des zweiten Transistors M2 abfallende DrainSource-Spannung $V_{DS}$ liegt an den nichtinvertierenden Eingängen (+) des ersten und zweiten Operationsverstärkers Op1, Op2 an. Der invertierende Eingang des ersten und zweiten Operationsverstärkers Op1, Op2 ist jeweils mit einer ersten bzw. einer zweiten Referenz-Spannungsquelle $V_{ref1}$, $V_{ref2}$ verbunden. Der Ausgang des ersten Operationsverstärkers Op1 wird schließlich wiederum über einen Inverter I geführt.

Diese Schaltung arbeitet im Nominal-Betriebs-Bereich von $I_{DS}$ = 200 mA in der Weise, daß der zweite Operationsverstärker Op2, der zur Dram-Regelung (REG) des zweiten (DMOS-) Transistors M2 dient, die Gatespannung des ersten Transistors M1 auf eine Spannung anhebt, die größer ist als seine MOS-Diodenspannung. Die Drainspannung des ersten Transistors M1 wird auf den Wert der zweiten Referenzspannung $V_{ref2}$ geregelt, so daß der als Komparator dienende erster Qperationsverstärker Op1 (Auswerteschaltung), der eine Erkennungsschwelle in Höhe der ersten Referenzspannung $V_{ref1}$ aufweist, keinen Unterstrom meldet (Ausgang USD = LOW).

Wenn der Laststrom $I_{last}$ durch den DMOS-Ausgangstransistor (zweiter Transistor M2) so weit abnimmt, daß der zweite Operationsverstärker Op2 die Gatespannung dieses Transistors M2 bereits unter seine MOS-Diodenspannung ziehen will, so kommt die erste Schaltungseinheit (Fig. 1) zum Einsatz, und der erste und der zweite Transistor M1, M2 wirken als Stromspiegel. Wenn der Laststrom $I_{last}$ kleiner als $I_{ref}$ * n1/n2 wird, sinkt die Drainspannung des zweiten Transistors M2, so daß die Komparatorschwelle der Auswerteschaltung unterschritten wird. Dadurch wird am Ausgang USD der Schaltung das Signal HIGH erzeugt, das als Erkennungssignal den Unterstrom anzeigt.

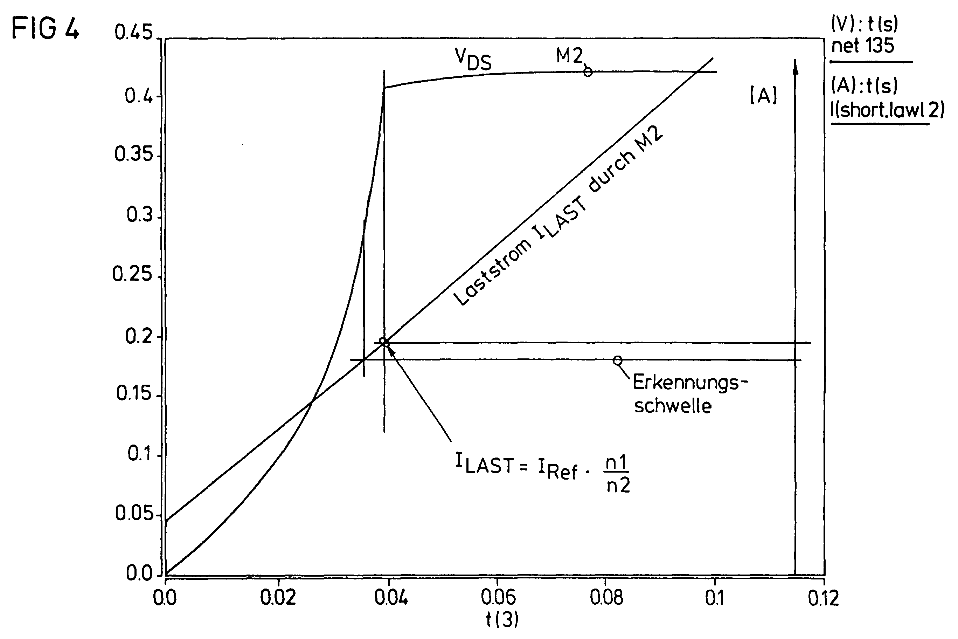

Figur 4 zeigt schließlich ein Diagramm des Verlaufes der Drain-Source-Spannung des DMOS-Ausgangstransistors (zweiter Transistor M2) bei steigenden Strom.

**Patentansprüche**

1. Schaltungsanordnung zur Unterstromerkennung an einem MOS-Leistungstransistor, **gekennzeichnet durch** eine erste Schaltungseinheit zur Erzeugung eines Stromspiegels mit einem ersten Transistor (M1), mit der bei geringem Laststrom an dem Leistungstransistor (M2) die an diesem abfallende Spannung mit einer ersten Referenzspannung verglichen und bei Unterschreiten der ersten Referenzspannung ein Unterstromsignal erzeugt wird, sowie eine zweite Schaltungseinheit zur Begrenzung der Drainspannung des Leistungstransistors (M2) bei hohem Laststrom auf einen maximalen Wert.

2. Schaltungsanordnung nach Anspruch 1, **dadurch gekennzeichnet**, dass der Leistungstransistor ein DMOS-Transistor (M2) mit n1-Zellen und der erste Transistor ein MOS-Transistor (M1) mit n2-Zellen ist.

**3.** Schaltungsanordnung nach Anspruch 1 oder 2, **dadurch gekennzeichnet**, dass der hohe Laststrom ein nominaler Betriebslaststrom ist, wobei die Drainspannung auf einen Wert von unter 0,6 V geregelt wird.

**4.** Schaltungsanordnung nach Anspruch 2 oder 3, **dadurch gekennzeichnet**, dass die erste Schaltungseinheit eine Referenz-Stromquelle aufweist und ein Unterstromsignal erzeugt wird, wenn der Laststrom $I_{last}$ kleiner oder gleich dem Wert von $I_{ref} * n1/n2$ ist.

**5.** Schaltungsanordnung nach Anspruch 4, **dadurch gekennzeichnet**, dass die erste Schaltungseinheit einen ersten Operationsverstärker (Op1) zum Vergleich der an dem Leistungstransistor (M2) abfallenden Spannung mit der ersten Referenzspannung ($V_{ref1}$) aufweist.

FIG 1

FIG 2

# FIG 3

EP 1 046 919 A2

FIG 4

(V) : t (s)
net 135
_____
(A) : t (s)
I(short.law I 2)

[A]

V_DS

M2

Laststrom $I_{LAST}$ durch M2

Erkennungsschwelle

$I_{LAST} = I_{Ref} \cdot \dfrac{n1}{n2}$

0.45
0.4
0.35
0.3
0.25
0.2
0.15
0.1
0.05
0.0

0.0   0.02   0.04   0.06   0.08   0.1   0.12
t (3)

7

FIG 5

I_last

I_ref

V+

I_ref

OP

VP

VN

n1-Zellen

Vds

M1

M2

n2-Zellen